# EUROPEAN PATENT APPLICATION

(11) **EP 2 565 980 A1**
(43) Date of publication of application: **06.03.2013**
(21) Application number: 11774599.2
(22) Date of filing: 22.04.2011
(51) Int. Cl.: H01M 14/00, H01L 31/04

(54) **DYE-SENSITIZED SOLAR CELL AND DYE-SENSITIZED SOLAR CELL MODULE**

(30) Priority: 14.05.2010 JP 2010112148; 29.04.2010 JP 2010104652
(71) Applicant: Nippon Steel & Sumikin Chemical Co., Ltd., Chiyoda-ku Tokyo 101-0021 (JP)
(72) Inventor: SASAKI, Kenryo, Kitakyusyu-shi Fukuoka 804-8503 (JP); TOKUYAMA, Takeshi, Kitakyusyu-shi Fukuoka 804-8503 (JP); KOHNO, Mitsuru, Kitakyusyu-shi Fukuoka 804-8503 (JP)
(74) Representative: Giles, Ashley Simon
(86) International application number: PCT/JP2011/002348
(87) International publication number: WO 2011/135811

(57) **Abstract**

There are particularly provided a dye-sensitized solar cell and a dye-sensitized solar cell module that can ensure a sealing structure for, in particular, external connection terminals and can prevent an electrolytic solution from leaking from a solar cell. A dye-sensitized solar cell 10 is provided with a laminated structure unit 18 including a porous semiconductor layer 12 with a dye adsorbed, a conductive metal layer 14 serving as an anode electrode and a conductor layer 16 serving as a cathode electrode. Respective one end portions of the conductive metal layer 14 and the conductor layer 16 extend from the laminated structure unit 18 to provide respective extending portions 14a and 16a. The whole surfaces of a first resin sheet 22 serving as a transparent substrate and a second resin sheet 24 serving as an opposite substrate are adhered and sealed. Parts of the extending portions 14a and 16a are exposed from openings 26 and 28 provided on the first resin sheet 22 to be formed into external connection terminals.

## Description

### Technical Field

The present invention relates to a sealing structure for components of a dye-sensitized solar cell.

### Background Art

Dye-sensitized solar cells are referred to as wet solar cells, Graetzel cells or the like, and are characterized by being produced without a silicon semiconductor and having an electrochemical cell structure represented by an iodine solution. Specifically, dye-sensitized solar cells have a simple structure in which an electrolytic solution (electrolyte) such as an iodine solution is arranged between a porous semiconductor layer, such as a titania layer, and a counter electrode made of a conductive glass plate (conductive substrate), the porous semiconductor layer being formed by burning titanium dioxide powder in a transparent conductive glass plate (transparent conductive substrate having a transparent conductive film laminated thereon) and allowing the powder to adsorb a dye.

Dye-sensitized solar cells have attracted attention as low-cost solar cells because materials therefor are inexpensive and no large-scale facility is required for production.

Dye-sensitized solar cells have been required to have further enhanced long-term reliability toward the practical use thereof, and have been studied from various viewpoints. One main problem lies in ensuring to prevent leakage of an electrolyte.

With respect to this, a method of heat sealing peripheral edge portions of a transparent electrode substrate and a counter electrode substrate into a pouched form, while parts of these substrates being remained, injecting an electrolytic solution from a not-sealed part, and then encapsulating the not-sealed part has been proposed (see Patent Literature 1). This method makes it possible to inject the electrolytic solution, while no pore being provided, and to suppress leakage of the electrolyte.

In this case, however, there is a possibility that the electrode substrate is curved to cause deformation, thereby causing cracks in the electrode. There is also a possibility that the electrode substrate degrades due to heat load during the heat sealing. In addition, there is also a possibility that leakage of the electrolyte is caused.

In order to resolve this failure, a method of arranging an article obtained by laminating a photoelectrode substrate and a counter electrode substrate between a pair of base material sheets, and adhering peripheral edge portions of the pair of base material sheets has been proposed (see Patent Literature 2). In this case, parts of the photoelectrode substrate and the counter electrode substrate are allowed to be projected from the peripheral edges of the base material sheets to the outside and formed into external electrodes (external connection terminals).

In this configuration, however, there is a possibility that a point at which the adhesion between the external electrode and the base material sheet is insufficient is generated to cause leakage of the electrolytic solution.

### Citation List

### Patent Literature

Patent Literature 1: Japanese Patent Laid-Open No. 2007-335228
Patent Literature 2: Japanese Patent Laid-Open No. 2010-80275

### Summary of Invention

### Technical Problem

A problem to be solved lies in that a sealing structure for components of a dye-sensitized solar cell, in particular, a sealing structure for external connection terminals is insufficient in techniques in which a conventional pouched sealing member is used, thereby making it impossible to certainly prevent a possibility that an electrolytic solution leaks from a solar cell.

### Solution to Problem

A dye-sensitized solar cell according to the present invention is provided with a laminated structure unit including a porous semiconductor layer with a dye adsorbed, a conductor layer serving as a cathode electrode, and a conductive metal layer serving as an anode electrode, wherein respective one end portions of the conductive metal layer and the conductor layer extend from the laminated structure unit to provide respective extending portions; and the laminated structure unit and the extending portions are sealed together with an electrolyte to be encapsulated, by a sealing material, and parts of the respective extending portions of the conductive metal layer and the conductor layer are exposed from the sealing material to be formed into external connection terminals.

In the dye-sensitized solar cell according to the present invention, preferably, the conductive metal layer serving as an anode electrode is arranged in contact with the porous semiconductor layer on the side of the conductor layer; a first resin sheet that has a larger flat surface area than the laminated structure unit, has transparency and is provided with an adhesive agent layer is arranged on the side of the porous semiconductor layer and a second resin sheet that has a larger flat surface area than the laminated structure unit and is provided with an adhesive agent layer is arranged on the side of the conductor layer so that the resin sheets sandwich the laminated structure unit as well as the respective extending portions of the conductive metal layer and the conductor layer; the respective extending portions of the conductive metal layer and the conductor layer and the outer peripheral portions of the first and second resin sheets, away from the extending portions, are adhered by the first and second resin sheets, and parts of the respective extending portions of the conductive metal layer and the conductor layer are exposed from an opening provided on any one of the first and second resin sheets to be formed into external connection terminals; and an electrolyte is encapsulated between the conductor layer and the conductive metal layer, and the first resin sheet is defined as a transparent substrate which light enters and the second resin sheet is defined as an opposite substrate.

In addition, preferably, the first resin sheet and second resin sheet are formed by a self-adhesive resin material.

In the dye-sensitized solar cell according to the present invention, preferably, a first resin sheet that has a larger flat surface area than the laminated structure unit, has transparency and is provided with an adhesive agent layer is arranged on the side of the porous semiconductor layer and a second resin sheet that has a larger flat surface area than the laminated structure unit and is provided with an adhesive agent layer is arranged on the side of the conductor layer so that the resin sheets sandwich the laminated structure unit as well as the respective extending portions of the conductive metal layer and the conductor layer; the whole surfaces of the first and second resin sheets are adhered, and parts of the respective extending portions of the conductive metal layer and the conductor layer are exposed from an opening provided on any one of the first and second resin sheets to be formed into external connection terminals; and an electrolyte is encapsulated, and the first resin sheet is defined as a transparent substrate which light enters and the second resin sheet is defined as an opposite substrate.

In addition, preferably, the first resin sheet and second resin sheet are formed by a self-adhesive resin material.

The dye-sensitized solar cell according to the present invention is preferably provided with a laminated structure including a transparent substrate which light enters, a conductive substrate that is provided opposite to the transparent substrate and serves as a cathode electrode, a porous semiconductor layer with a dye adsorbed, and a conductive metal layer that is arranged in contact with the porous semiconductor layer and serves as an anode electrode, wherein an electrolyte is encapsulated; respective one end portions of the conductor layer of the conductive substrate and the conductive metal layer extend from the laminated structure to provide respective extending portions; the whole surfaces of the laminated structure as well as the respective extending portions of the conductor layer of the conductive substrate and the conductive metal layer are sealed by a sealing member having transparency, and parts of the respective extending portions of the conductor layer of the conductive substrate and the conductive metal layer are exposed from an opening provided on the sealing member to be formed into external connection terminals.

In addition, preferably, the sealing member is constituted by two resin sheets each having an adhesive agent layer provided on the whole surface thereof, at least one of the two resin sheets being made of a transparent material, the resin sheet made of a transparent material is arranged on the transparent substrate, the other resin sheet is arranged below the conductive substrate, and the whole surfaces of the laminated structure as well as the respective extending portions of the conductor layer of the conductive substrate and the conductive metal layer are adhered between the two resin sheets.

In addition, preferably, the outer peripheral portions of the two resin sheets each having an adhesive agent layer provided on the whole surface thereof, away from the laminated structure as well as the respective extending portions of the conductor layer of the conductive substrate and the conductive metal layer, are heat sealed.

In addition, preferably, the conductive metal layer is a porous layer arranged in contact with the porous semiconductor layer on the side opposite to the transparent substrate.

In the dye-sensitized solar cell according to the present invention, preferably, the extending portion of the conductive metal layer is formed by a non-porous layer.

The dye-sensitized solar cell according to the present invention is a dye-sensitized solar cell wherein a multiplicity of the dye-sensitized solar cell is arrayed electrically in series or in parallel and the whole is sealed.

### Advantageous Effects of Invention

The dye-sensitized solar cell according to the present invention can ensure the sealing structure for cell components of the dye-sensitized solar cell, in particular, the sealing structure for the external connection terminals and can prevent the electrolytic solution from leaking from the solar cell because the periphery of the laminated structure unit or laminated structure such as electrodes and the extending portions of the conductor layer of the conductive substrate and the like extending from the laminated structure unit or laminated structure are at least sealed and parts of the extending portions are exposed from the opening provided on the sealing member to be formed into the external connection terminals.

A dye-sensitized solar cell module according to the present invention can achieve the effects of the dye-sensitized solar cell because it is formed while a plurality of the dye-sensitized solar cells being arrayed electrically in series or in parallel and the whole thereof being sealed.

### Brief Description of Drawings

[Figure 1] Figure 1 is a schematic side cross-sectional view of a dye-sensitized solar cell according to a first example of the present embodiment.
[Figure 2] Figure 2 is a plan view of the dye-sensitized solar cell according to the first example of the present embodiment.
[Figure 3] Figure 3 is a schematic side cross-sectional view of a dye-sensitized solar cell according to a third example of the present embodiment.
[Figure 4] Figure 4 is a schematic side cross-sectional view of a variant of the dye-sensitized solar cell according to the third example of the present embodiment.
[Figure 5] Figure 5 is a view for illustrating a heat sealing structure of the variant of the dye-sensitized solar cell according to the third example of the present embodiment.
[Figure 6] Figure 6 is a plan view of a dye-sensitized solar cell module according to a fourth example of the present embodiment.
[Figure 7] Figure 7 is a plan view of a dye-sensitized solar cell according to a second example of the present embodiment.

### Description of Embodiments

An embodiment of the present invention will be described below with reference to the drawings.

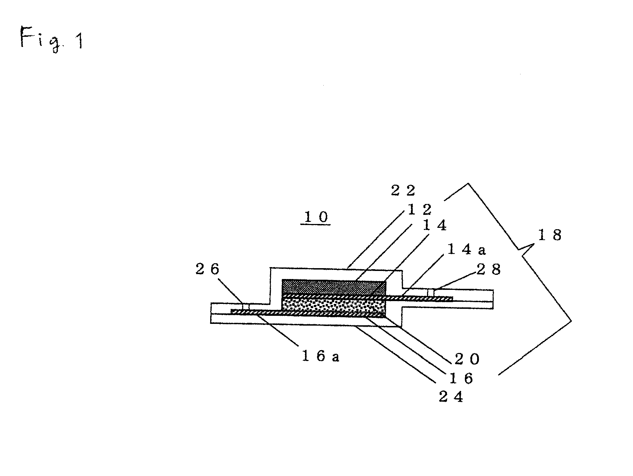

In principle, a dye-sensitized solar cell according to the present embodiment is provided with a laminated structure unit including a porous semiconductor layer with a dye adsorbed, a conductor layer serving as a cathode electrode, and a conductive metal layer serving as an anode electrode, wherein respective one end portions of the conductive metal layer and the conductor layer extend from the laminated structure unit to provide respective extending portions, and the laminated structure unit and the extending portions are sealed together with an electrolyte to be encapsulated, by a sealing material, and parts of the respective extending portions of the conductive metal layer and the conductor layer are exposed from the sealing material to be formed into external connection terminals (see, for example, Figure 1).

This makes it possible to realize a sealing structure having a high sealing (encapsulating) ability for cell components such as electrodes (laminated structure unit, laminated structure) and external electrodes (external connection terminals) extending from the electrodes.

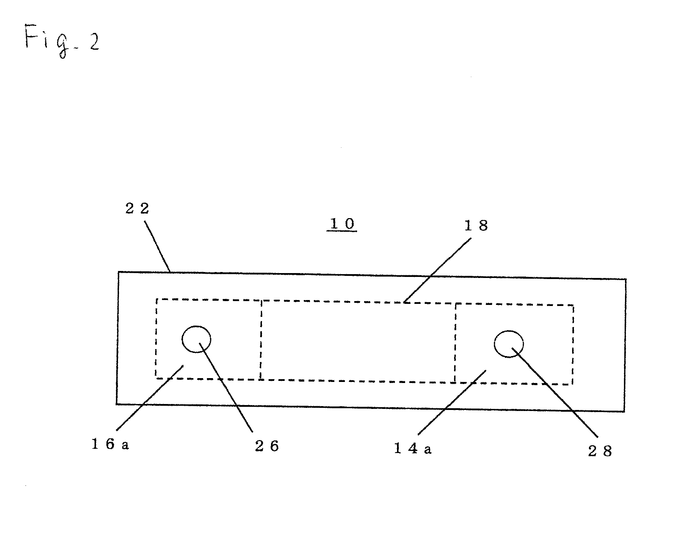

First, a dye-sensitized solar cell according to a first example of the present embodiment will be described with reference to a schematic side cross-sectional view of Figure 1 and a plan view of Figure 2.

A dye-sensitized solar cell 10 according to the first example of the present embodiment is provided with a laminated structure unit 18 including a porous semiconductor layer 12 with a dye adsorbed, a conductive metal layer 14 arranged in contact with the porous semiconductor layer 12 and serving as an anode electrode, and a conductor layer 16 serving as a cathode electrode. In Figure 1, reference numeral 20 denotes an electrolyte (electrolytic solution) to be encapsulated.

Respective one end portions of the conductive metal layer 14 and the conductor layer 16 extend from the laminated structure unit 18 to provide respective extending portions 14a and 16a.

A first resin sheet 22 is provided on the upper surface of the laminated structure unit 18 on the side of the porous semiconductor layer 12 and a second resin sheet 24 is provided on the lower surface of laminated structure unit 18 on the side of the conductor layer 16 so that the resin sheets sandwich the laminated structure unit 18. Both of the first resin sheet 22 and second resin sheet 24 are formed by a self-adhesive resin material or a non self-adhesive resin material, and have a larger flat surface area than the laminated structure unit 18. Herein, the self-adhesive material means a material, for example, a solder resist and a bonding sheet material, which itself has chemical interactive properties such as a hydrogen bond, a covalent bond and an intermolecular force, and mechanical interactive properties such as an anchor effect to exert adhesiveness, and which requires no additional adhesive agent. A resin material other than the self-adhesive material is herein referred to as a non self-adhesive resin material. The details of these resin materials will be described later.

Hereinafter, while the case where non self-adhesive resin materials are used for the first resin sheet 22 and second resin sheet 24 will be described as an example, the case is the same as the case where self-adhesive materials are used therefor except that an adhesive agent layer described below is omitted.

In the case where non self-adhesive resin materials are used for the first resin sheet 22 and second resin sheet 24, an adhesive agent layer is provided on one surface of each of the first resin sheet 22 and second resin sheet 24, the surface on which the adhesive agent layer is provided is directed inside to cover the laminated structure unit 18 as well as the extending portions 14a and 16a. The first resin sheet 22 has transparency. That is, the first resin sheet 22 is transparent or translucent. In contrast, the second resin sheet 24 may have transparency or no transparency. It is to be noted that in Figure 1, the representation of the adhesive agent layers provided on the lower surface of the first resin sheet 22 and the upper surface of the second resin sheet 24 is omitted.

The whole surfaces of the first and second resin sheets 22 and 24 are adhered and sealed, and thus, the laminated structure unit 18 and the respective extending portions 14a and 16a of the conductive metal layer 14 and conductor layer 16 are encapsulated by the first and second resin sheets 22 and 24.

Parts of the extending portions 14a and 16a are exposed from openings 26 and 28 provided on the first resin sheet 22 to be formed into external connection terminals. In this case, since the respective extending portions 14a and 16a of the conductive metal layer 14 and conductor layer 16 are adhered and sealed by the first and second resin sheets 22 and 24, there is less possibility that the electrolyte 20 leaks from the openings 26 and 28. It is to be noted that the openings 26 and 28 may be provided on the second resin sheet 24, and one opening may be provided on the first resin sheet 22 and the other opening may be provided on the second resin sheet 24.

The first resin sheet 22 is a transparent substrate which light enters, and the second resin sheet 24 is an opposite substrate.

It is to be noted that in the laminated structure unit 18 illustrated in Figure 1, the conductive metal layer usually provided on the transparent substrate is omitted, and the conductive metal layer 14 is provided on the porous semiconductor layer 12 on the side of the conductor layer 16, in other words, on the side of the electrolyte 20. The conductive metal layer 14 is formed as a porous layer in order to allow the electrolyte 20 to permeate into the porous semiconductor layer 12 via the conductive metal layer 14. Alternatively, the laminated structure unit may have such a configuration that the conductive metal layer is provided on the transparent substrate as in the common cell.

In the case where material resins for the first and second resin sheets 22 and 24 are non self-adhesive resin materials, examples thereof include PP, PE, PS, ABS, PS, PC, PMMA, PVC, PA, POM, PET, PEN, PIB, PVB, PA6, polyimide, polyamide, polyolefin, polyester, polyether, a cured acrylic resin, a cured epoxy resin, a cured silicone resin, various engineering plastics, and a cyclic polymer obtained by metathesis polymerization. The first and second resin sheets 22 and 24 may be formed by the same material, or may be formed by materials different from each other.

In order to improve the durability of the dye adsorbed on the porous semiconductor layer 12, a material absorbing light wavelengths at 200 nm to 400 nm can be used for, can be separately pasted on, or can be coated on the first resin sheet (transparent substrate) 22. In order to improve availability of light entering the first resin sheet 22, an antireflective film can also be provided on the outermost surface of the first resin sheet 22.

A material for the adhesive agent layer provided on parts or the whole surfaces of the first and second resin sheets 22 and 24, that can be suitably used, is, for example, an EVA resin emulsion adhesive agent containing as a main component a resin (EVA) obtained by copolymerization of ethylene and vinyl acetate, but not limited thereto, and an appropriate adhesive agent material, such as a polyolefin, polyester, polyurethane, polyacrylic, epoxy, ionomer, disulfide, polyimide or silicone resin can be used.

For the purpose of reinforcing the adhesion of the adhesive agent layer provided on a part or the whole surface of each of the first and second resin sheets 22 and 24 or subjecting incident light to effective photoelectric conversion, the resin sheet can be subjected to a surface treatment, wherein an appropriate oxidation treatment by ozone, oxygen plasma, dichromic acid, permanganic acid or the like, an appropriate coupling agent treatment by a silane coupling agent, a silylating agent, silanol, organosilane, a titanate coupling agent, titanalkoxide or the like, or an appropriate sputter deposition or laminating treatment by silica, alumina, zirconia, FTO, ITO, ZTO, aluminum, titanium, tungsten, platinum, carbon, magnesium fluoride, silicon monoxide, chromium, gold, nickel, copper, rhodium, tin or silver can be used therefor.

The thickness of the adhesive agent layer is not particularly limited, and can be, for example, about 0.5 µm to about 1 µm. Parts of the first and second resin sheets 22 and 24, the parts being not in contact with the porous semiconductor layer 12, are preferably thicker than the parts being in contact therewith. For example, in the case where the total of the thicknesses of the parts of the first and second resin sheets 22 and 24, the parts being not in contact with the porous semiconductor layer 12, is preferably greater than that of the parts being in contact therewith by the thickness of the laminated structure unit 18, the adhesion is further reinforced and thus the case is preferable.

On the other hand, in the case where self-adhesive resin materials requiring no adhesive agent are used for the material resins of the first and second resin sheets 22 and 24, examples thereof include monomer dispersants or prepolymers of various polymers such as polyolefin, polyester, polyurethane, polyacrylic, epoxy, ionomer, disulfide, polyimide and silicone polymers, those obtained by subjecting various polymers to a surface treatment such as a chemical treatment by an acid/alkali, a corona treatment, a plasma treatment, or a mechanical roughing treatment, and a thermoplastic resin.

In the case where these self-adhesive resin materials are used, the adhesion is performed by heating, pressurizing, light irradiation or the like.

For the conductive metal layer 14, a metal mesh, a metal layer on which innumerable pores are previously formed or a porous metal layer formed by a thermal spraying or thin film formation method can be used.

A material for the conductive metal layer 14 is not particularly limited, and preferably is a material of one or two or more metals selected from the group consisting of Ti, W, Ni, Pt, Ta, Nb, Zr and Au, a compound thereof, or a material covered therewith, and particularly preferably Ti or a composite material of Ti sintered by using a sintering aid. The sintering aid may be an appropriate material commonly employed, and a material such as Ni, B₄C or Y₂O₃ can be used therefor and Ni is particularly preferable. The sintering aid further preferably has a particle size of 100 nm or less in diameter. This makes it possible to obtain a conductive metal layer 14 good in corrosion resistance against iodine for use as a charge transport ion in the electrolyte 20.

The conductive metal layer 14 may have through-pores penetrating from the front of the layer to the rear thereof, and preferably has through-pores formed communicating so as to have isotropy also in the direction along with the plane of the layer, that is, in the three-dimensionally all directions. This allows the electrolyte 20 passing through the conductive metal layer 14 to permeate into each part of the porous semiconductor layer 12 uniformly.

Since the conductive metal layer on which isotropic through-pores are formed has a large number of pores having planar isotropy and also communicating and being distributed even on the surface portion in contact with the porous semiconductor layer 12, the conductive metal layer has a large contact area with the porous semiconductor 12 that is aggregate of particles, and the pores on the surface of the conductive metal layer engage with the particles on the surface of the porous semiconductor layer 12 in the so-called state of snapping. This makes the joining force between the conductive metal layer and the porous semiconductor layer 12 larger, and there is less possibility that cracks occur, for example, in an electrical joining step by heating at about 500°C.

The thickness of the conductive metal layer 14 is not particularly limited, and preferably 0.2 µm to 600 µm and further preferably 0.3 µm to 100 µm. In the case where the thickness of the conductive metal layer 14 is less than 0.2 µm, the electrical resistance of the conductive metal layer 14 may be raised. On the other hand, the thickness of the conductive metal layer 14 exceeds 600 µm, the flow resistance of the electrolyte 20 passing through the inside of the conductive metal layer 14 is too high, and the passage of the electrolyte 20 may be inhibited. It is to be noted that the electrical resistance of the conductive metal layer 14 is preferably 1 Ω/sq or less.

The specific surface area of the metal porous material constituting the conductive metal layer 14 is preferably 0.1 m²/g or more. This can make the joining force between the conductive metal layer 14 and the porous semiconductor layer 12 larger.

The upper limit of the specific surface area of the metal porous material is not particularly limited, and is sufficiently, for example, about 10 m²/g.

The specific surface area can be measured by a mercury intrusion method. The measurement of the specific surface area by a mercury intrusion method is performed by calculating as lateral areas intrusion volumes according to a cylindrical micropore model using mercury intrusion porosimeters (manufactured by CARLOERBA INSTRUMENTS, Pasca1140 and Pasca1440, measurable range: specific surface area 0.1 m²/g or more, micropore distribution: 0.0034 to 400 µm) in pressure ranges from 0.3 kPa to 400 kPa and from 0.1 MPa to 400 MPa, and integrating them. It is to be noted that a porosity and a pore diameter described later are simultaneously obtained by this measurement.

The metal porous material preferably has a porosity of 30 to 60% by volume and a pore diameter of 1 µm to 40 µm. If the porosity is less than 30% by volume, the electrolyte is insufficiently diffused in the metal porous material, and thus uniform permeation into the conductive metal layer 14 may be impaired. On the other hand, if the porosity exceeds 60% by volume, the joining force between the conductive metal layer 14 and the porous semiconductor layer 12 may be impaired. In addition, if the pore diameter is less than 1 µm, the electrolyte is insufficiently diffused in the metal porous material, and also the snapping of the pores on the conductive metal layer 14 and the particles of the porous semiconductor layer 12 is made insufficient and thus the joining force between the conductive metal layer 14 and the porous semiconductor layer 12 may be impaired. On the other hand, if the pore diameter exceeds 40 µm, the contact area between the conductive metal layer 14 and the porous semiconductor layer 12 is made smaller, and thus the joining force between the conductive metal layer 14 and the porous semiconductor layer 12 may be impaired.

The laminated structure 18 may be provided with a porous insulation layer between the conductive metal layer 14 and the electrolyte 20. In this case, when a glass fiber molded body or the like is used for the porous insulation layer, the porous semiconductor layer 12 can be obtained by forming the conductive metal layer 14 on the porous insulation layer by an appropriate film formation method such as a press method or a sputter method, applying the material for the porous semiconductor layer 12 on the conductive metal layer 14, and firing the resultant.

The extending portion 14a can be provided on a structure in which the end portion of the conductive metal layer 14 is elongated and drawn from the laminated structure unit 18. However, the conductive metal layer 14 is a porous film, and therefore, if the extending portion 14a is formed by the same material as the conductive metal layer 14, the electrolyte may leak out from the extending portion 14a. Thus, the extending portion 14a is preferably configured to be formed by a non-porous material different from the material for the conductive metal layer 14 and to be electrically connected to the conductive metal layer 14.

The extending portion 16a can be provided in a configuration in which the end portion of the conductor layer 16 is elongated and drawn from the laminated structure unit 18 as in the case of the extending portion 14a, and may also be configured to be electrically connected to the conductor layer 16 by a different material. While the conductor layer 16 is a catalyst film or one in which a conductive film is laminated on the catalyst film, as described later, it is only necessary that in the latter case where a conductive film is laminated on a catalyst film, only the conductive film extends.

On the other hand, in the case where the conductor layer (conductive metal layer) is provided on the transparent substrate as in the case of the usual cell, the conductor layer is not particularly limited, and may be, for example, an ITO film (tin-doped indium film), an FTO film (fluorine-doped tin oxide film), a SnO₂ film, or the like. The conductor layer 16 may also be a material of one or two or more metals selected from the group consisting of Ti, W, Ni, Pt, Ta, Nb, Zr and Au, a compound thereof, a material covered therewith, or a material in which a conductive film such as carbon is laminated. It is to be noted that while the conductor layer provided on the transparent substrate needs to have transparency, it does not need to be a porous layer like the conductive metal layer 14, and such a porous layer may cause such a possibility that conductivity is inhibited.

In this case, the conductor layer (conductive metal layer) may be formed by an appropriate method such as sputter, deposition or application while being integrated with the first resin sheet 24.

The conductive film of the conductor layer 16 can be formed by the same material as that for the conductive metal layer 14. The surface of the conductor layer 16, facing towards the electrolyte 20, is provided with a catalyst film made of a noble metal, such as a platinum film, high surface area carbon, a catalytic conductive polymer, or the like. The conductor layer 16 may be provided with only the catalyst film such as a platinum film while the conductive film such as ITO being omitted. In this case, the catalyst film acts as a conductive film.

The thickness of the conductor layer 16 is not particularly limited, and is preferably for example about several tens nm or more from the viewpoint of obtaining good conductivity.

The conductor layer 16 may also be a self-supported film such as a metal foil, mesh or net, and may be formed by an appropriate method such as sputter, deposition or application while being integrated with the second resin sheet 24.

With respect to the porous semiconductor layer 12, an appropriate metal oxide such as TiO₂, ZnO or SnO₂ can be used for a semiconductor material, and among them, TiO₂ is preferable.

The thickness of the porous semiconductor layer 12 is not particularly limited, and is preferably 10 µm or more.

The particle size of TiO₂ fine particles to be fired is not particularly limited, and is preferably, for example, about 1 nm to about 100 nm.

The porous semiconductor layer 12 is obtained by firing the semiconductor material at a temperature of 300°C or higher, preferably 350°C or higher, further preferably 400°C or higher. On the other hand, the upper limit of the firing temperature is not particularly determined, and it is a temperature sufficiently lower than the melting point of the material for the porous semiconductor layer 12 and preferably a temperature of 550°C or lower. In the case where titanium oxide (titania) is used as the material for the porous semiconductor layer 12, it is preferably fired in the state of an anatase crystal in which the conductivity of titanium oxide is high at such a temperature that does not allow to transfer to a rutile crystal.

The porous semiconductor layer 12 is suitably obtained by firing the semiconductor material provided on a thin layer, and then repeating an operation of providing an additional thin layer and firing the resultant to have a desired thickness.

The dye adsorbed by the porous semiconductor layer 12 is one having absorption at a wavelength from 400 nm to 1200 nm, and examples thereof include metal complexes such as a ruthenium dye, a phthalocyanine dye, an osmium-based dye, an iron-based dye and a platinum-based dye, and organic dyes such as a cyanine dye, a methine-based dye, a mercurochrome-based dye, a xanthene-based dye, a porphyrin-based dye, a phthalocyanine-based dye, a subphthalocyanine-based dye, an azo-based dye and a coumarin-based dye. An adsorbing method is not particularly limited, and for example, a so-called impregnation method for impregnating a conductive metal layer, on which a porous semiconductor layer is formed, with a dye solution to allow the dye to be chemically adsorbed on the surface of fine particles can be used.

The electrolyte (electrolytic solution) 20 is one containing iodine, a lithium ion, an ion liquid, t-butyl pyridine, and the like, and, for example, in the case of iodine, an oxidation reduction couple including a combination of an iodide ion and iodine can be used. The oxidation reduction couple contains an appropriate solvent that can dissolve the couple. The oxidation reduction couple may contain a reverse electron preventing agent based on pyridine, cholic acid or carboxylic acid as other additives. A gelation agent for quasi-solidification can also be used.

The electrolyte (electrolytic solution) 20 may be one filled in a space defined between the conductive metal layer 14 and the conductor layer 16, or may be one with which a porous spacer provided between the conductive metal layer 14 and the conductor layer 16 is impregnated.

The first resin sheet (transparent substrate) 22 and the porous semiconductor layer 12 are adhered in close contact with each other, thereby making it possible to improve availability of light entering the first resin sheet 22.

On the other hand, in order to arrange the conductive metal layer 14 and the conductor layer 16 so as not to be in contact with each other, for example, an insulation layer having corrosion resistance to an electrolyte 6 and having voids enough not to interrupt the diffusion of electrolyte ions, such as glass paper, a glass cloth, a Teflon sheet (Teflon is the registered trademark), a PP sheet, a PE sheet or a SiO₂ film by a sputter method, is preferably provided. The interval between the conductive metal layer 14 and the conductor layer 16 is preferably 150 µm or less.

The dye-sensitized solar cell 10 described above can be obtained by, for example, the following production method.

First, the laminated structure unit 18 can be obtained by an appropriate method commonly employed.

In this case, the conductive metal layer 14 can also be obtained by an appropriate production method. For example, a method of applying on an appropriate substrate a metal paste prepared by mixing a metal fine powder with an appropriate solvent, heating the resultant to a firing temperature under such an atmosphere condition that oxygen is substantially absent, and then transferring a metal paste fired body on the porous semiconductor layer 12 can be employed. In this case, the whole is fired at the firing temperature of the material for the porous semiconductor layer 12 in the state where the metal paste fired body is transferred on the material for the non-fired porous semiconductor layer 20. Also when the metal paste fired body is transferred on the fired porous semiconductor layer 12, the whole is preferably heated again at an appropriate temperature. As the conductive metal layer 14, one obtained by firing the thicker metal paste and then slicing it to a desired thickness may also be laminated on the porous semiconductor layer 12.

For the conductive metal layer 14, a commercially available metal fine powder sintered body sheet, for example, trade name: Tiporous (produced by Osaka Titanium Technologies Co., Ltd.) may also be used.

The first and second resin sheets 22 and 24 sandwiching the laminated structure unit 18 and the like are adhered under pressure at a pressure of, for example, 0.05 to 5 MPa for about 0.5 seconds to about 10 minutes by, for example, a press lamination method, and sealed. In this case, they may also be heated to a temperature from, for example, about 40 to about 200°C and treated, depending on the type of the resin sheet material.

The openings 26 and 28 provided on the first and second resin sheets 22 and 24 may be previously formed on the first and second resin sheets 22 and 24, or may be formed after sealing the laminated structure unit 18 and the like.

It is to be noted that in order to encapsulate the electrolyte 20 after forming the laminated structure unit 18, a method of previously forming or forming, after sealing, an opening communicating with the laminated structure unit 18 on the second resin sheet 24, injecting the electrolyte 20 from the opening, and then encapsulating the opening can be employed. From the viewpoint of preventing air from incorporating into the electrolyte 20, a method of using a vacuum pump or the like from the opening to make the laminated structure unit 18 vacuum, injecting the electrolyte 20, and then encapsulating the opening is preferable.

The dye-sensitized solar cell 10 described above can be sealed by a simple method of using the first and second resin sheets 22 and 24 serving as a substrate, without a special member for sealing. The dye-sensitized solar cell 10 can ensure the sealing structure for components of the dye-sensitized solar cell, in particular, the sealing structure for the external connection terminals and can prevent the electrolytic solution from leaking from the solar cell.

Then, a dye-sensitized solar cell according to a second example of the present embodiment will be described.

The dye-sensitized solar cell according to the second example of the present embodiment is provided with a laminated structure unit including a porous semiconductor layer with a dye adsorbed, a conductor layer serving as a cathode electrode, and a conductive metal layer serving as an anode electrode, arranged in contact with the porous semiconductor layer on the side of the conductor layer, wherein respective one end portions of the conductive metal layer and the conductor layer extend from the laminated structure unit to provide respective extending portions; a first resin sheet that has a larger flat surface area than the laminated structure unit, has transparency and is provided with an adhesive agent layer is arranged on the side of the porous semiconductor layer and a second resin sheet that has a larger flat surface area than the laminated structure unit and is provided with an adhesive agent layer is arranged on the side of the conductor layer so that the resin sheets sandwich the laminated structure unit as well as the respective extending portions of the conductive metal layer and the conductor layer; the respective extending portions of the conductive metal layer and the conductor layer and the outer peripheral portions of the first and second resin sheets, away from the extending portions, are adhered by the first and second resin sheets and the resultant is sealed, and parts of the respective extending portions of the conductive metal layer and the conductor layer are exposed from an opening provided on any one of the first and second resin sheets to be formed into external connection terminals; and an electrolyte is encapsulated between the conductor layer and the conductive metal layer, and the first resin sheet is defined as a transparent substrate which light enters and the second resin sheet is defined as an opposite substrate.

That is, the basic configuration of the dye-sensitized solar cell according to the second example of the present embodiment is the same as that of the dye-sensitized solar cell 10.

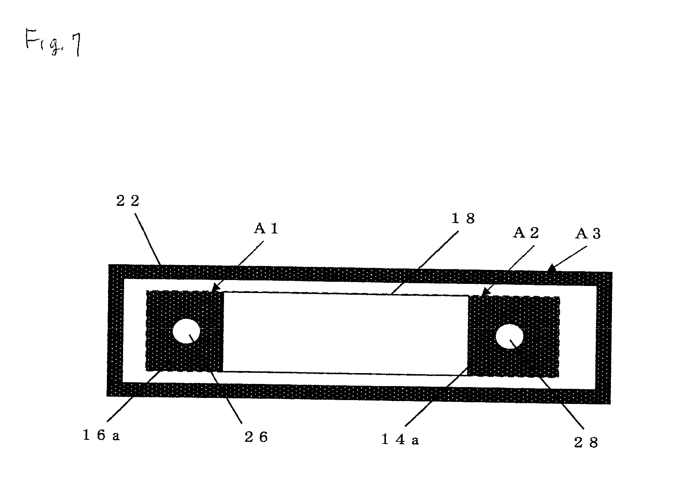

The dye-sensitized solar cell according to the second example of the present embodiment is different from the dye-sensitized solar cell 10 in that it is limited to a so-called cubic electrode, that is, the conductive metal layer serving as an anode electrode of the laminated structure unit is arranged in contact with the porous semiconductor layer on the side of the conductor layer, and in that as illustrated in Figure 7, only the respective extending portions 14a and 16a of the conductive metal layer and the conductor layer, and outer peripheral portions (indicated by arrows A1, A2 and A3 in Figure 7) of the first and second resin sheets, away from the extending portions 14a and 16a, are adhered by the first and second resin sheets and sealed as a whole.

The dye-sensitized solar cell according to the second example of the present embodiment can be obtained by, for example, protecting by a mask, points corresponding to the extending portions of the first and second resin sheets and a region corresponding to the points on the laminated structure unit from which the outer peripheral portions of the first and second resin sheets are eliminated, applying an adhesive agent to the first and second resin sheets to form an adhesive agent layer, and then using the first and second resin sheets, from which the mask is removed, to seal the resultant.

The dye-sensitized solar cell according to the second example of the present embodiment can certainly avoid failures such as occurrence of cracks on the porous semiconductor layer because the first resin sheet is not adhered to the porous semiconductor layer of the laminated structure unit and thus, even if tension stress is applied to the first resin sheet due to any reason at the time of handling the dye-sensitized solar cell, the stress may not act on the porous semiconductor layer as it is.

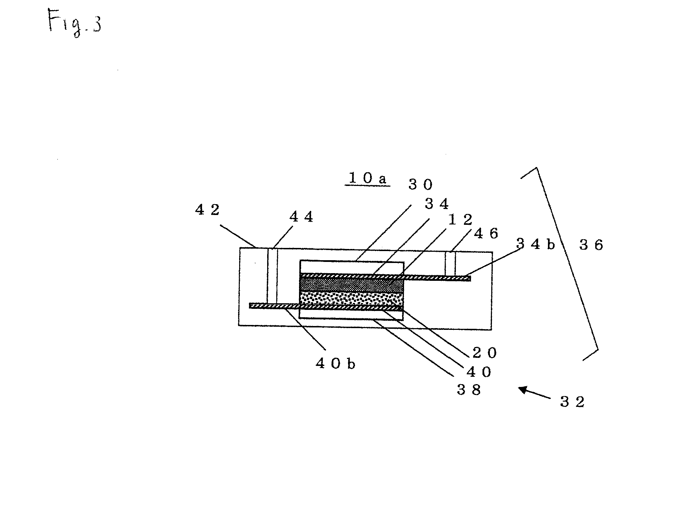

Then, a dye-sensitized solar cell according to a third example of the present embodiment will be described with reference to a schematic side cross-sectional view of Figure 3.

Herein, overlapping description is omitted unless otherwise noted, because each member of the dye-sensitized solar cell according to the third example of the present embodiment, such as a conductive metal layer, can have the same configuration as that of the dye-sensitized solar cell 10.

A dye-sensitized solar cell 10a according to the third example of the present embodiment is provided with a laminated structure 36 including a transparent substrate 30 which light enters, a conductive substrate 32 that is provided opposite to the transparent substrate 30 and that serves as a cathode electrode, a porous semiconductor layer with a dye adsorbed 12, and a conductive metal layer that is arranged in contact with the porous semiconductor layer 12 and serves as an anode electrode 34, wherein an electrolyte 20 is encapsulated. The conductive substrate 32 is configured from a substrate 38 and a conductor layer 40 formed on the substrate 38.

While the conductive metal layer 34 is provided on the transparent substrate 30 in Figure 3, the conductive metal layer 34 may be formed on the porous semiconductor layer 12 on the side of the electrolyte 20 instead of this configuration, and such a case is the same as in the case of the dye-sensitized solar cell 10.

Respective one end portions of the conductor layer 40 of the conductive substrate 32 and the conductive metal layer 34 extend from the laminated structure 36 to provide respective extending portions 40b and 34b, and the whole surfaces of the laminated structure 36 as well as the respective extending portions 40b and 34b of the conductor layer 40 of the conductive substrate 32 and the conductive metal layer 34 are sealed by a sealing member 42 having transparency. In addition, parts of the respective extending portions 40b and 34b of the conductor layer 40 of the conductive substrate 32 and the conductive metal layer 34 are exposed from openings 44 and 46 provided on the sealing member 42 to be formed into external connection terminals.

The transparent substrate 30 and the substrate 38 of the conductive substrate 32 may be, for example, a glass plate, or may be a resin plate having flexibility (flexible transparent substrate and flexible conductive substrate).

The dye-sensitized solar cell 10a can be produced by, for example, the following production method.

First, the laminated structure 36 can be obtained by an appropriate method commonly employed.

Then, for example, the laminated structure 36 on which the extending portions 40b and 34b are provided is set to a mold by a molding technique such as a transfer mold forming method, and a resin melt (material for the sealing member 42) is flowed into the mold and molded under pressure to encapsulate (cast) the laminated structure 36 and the like into the resin. The openings 44 and 46 can be formed at the time of molding or after molding.

Examples of a resin for use as the resin melt include an epoxy resin.

It is to be noted that the openings 44 and 46 and the opening for injecting the electrolyte 20 may be formed at any period of molding or post-molding.

The dye-sensitized solar cell 10a according to the third example of the present embodiment can certainly encapsulate the laminated structure 36 on which the extending portions 40b and 34b are provided, thereby making it possible to achieve the same effects as those of the dye-sensitized solar cell 10. In this time, the mold is used depending on the shape such as the dimension of the laminated structure 36, and thus the laminated structure 36 may not be restricted by the shape.

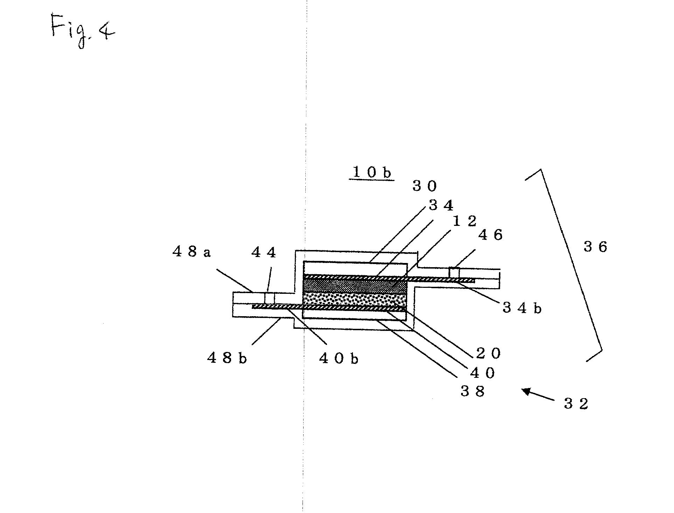

Then, a variant of the dye-sensitized solar cell according to the third example of the present embodiment will be described with reference to a schematic side cross-sectional view of Figure 4.

A dye-sensitized solar cell 10b according to the variant illustrated in Figure 4 has a configuration of a sealing member different from the configuration of the dye-sensitized solar cell 10a.

That is, the dye-sensitized solar cell 10b has a sealing member constituted by, for example, polyester-based or polyamide-based two resin sheets 48a and 48b each having an adhesive agent layer provided on the whole surface thereof, at least one of the sheets being made of a transparent material. For the resin sheets 48a and 48b, those having a sufficiently larger flat surface area than the laminated structure 36 are used.

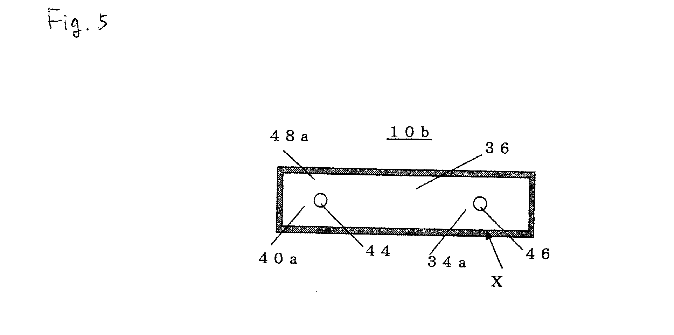

The resin sheet 48a made of a transparent material is arranged above the transparent substrate 30 while the adhesive agent layer being directed downward, the other resin sheet 48b is arranged below the conductive substrate 30 while the adhesive agent layer being directed upward, and the whole surfaces of the laminated structure 36 as well as the respective extending portions 40a and 34a of the conductor layer 40 of the conductive substrate 32 and the conductive metal layer 34 are adhered between the two resin sheets 48a and 48b. In this case, as illustrated in Figure 5, it is more preferable that the outer peripheral portions of the two resin sheets 48a and 48b, away from the laminated structure 36 as well as the respective extending portions 40a and 34a of the conductor layer 40 of the conductive substrate 32 and the conductive metal layer 34, be heat sealed (in Figure 5, an arrow X denotes a heat sealed portion).

It is to be noted that the openings 44 and 46 and the opening for injecting the electrolyte 20 may be previously formed on the resin sheets 48a and 48b, or may be formed after sealing.

The dye-sensitized solar cell 10b, in which the two resin sheets are used for sealing (encapsulating), can ensure the sealing structure for components of the dye-sensitized solar cell, in particular, the sealing structure for the external connection terminals and can prevent the electrolytic solution from leaking from the solar cell.

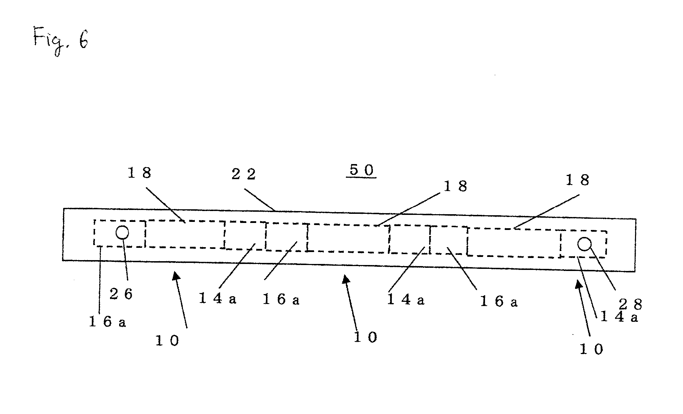

Then, a dye-sensitized solar cell module according to a fourth example of the present embodiment is described with reference to Figure 6.

The dye-sensitized solar cell module according to the fourth example of the present embodiment is one in which a plurality of any of the dye-sensitized solar cells 10, 10a and 10b are arrayed electrically in series or in parallel. The dye-sensitized solar cell module is entirely sealed.

In a dye-sensitized solar cell module 50, as illustrated in a plan view of Figure 6, dye-sensitized solar cells 10 are laid in a line, and the extending portions 14a and the extending portions 16a of the dye-sensitized solar cells 10 adjacent to each other are electrically connected, respectively.

External connection terminals on both ends of the line of the dye-sensitized solar cells 10 can be used to obtain the output of the plurality of dye-sensitized solar cells 10 arrayed in series.

On the other hand, the dye-sensitized solar cells 10 adjacent to each other are independently arranged, that is, the extending portion 14a and the extending portion 16a adjacent to each other are arranged without being electrically connected, and an extracted wiring shared by the respective extending portions 14a is provided and an extracted wiring shared by the respective extending portions 16a is also provided, thereby making it possible to obtain the output of the plurality of the dye-sensitized solar cells 10 arrayed in parallel.

### Examples

Hereinafter, Examples of the present invention will be described. The present invention is not limited to the Examples.

### (Example 1)

A titania paste (trade name: NanoxideD, produced by Solaronix SA) was printed on a range of 5 mm x 20 mm on a porous Ti sheet, having a thickness of 100 µm, (trade name: Tiporous, produced by Osaka Titanium Technologies Co., Ltd.), dried, and fired in air at 400°C for 30 minutes. An operation in which an additional titania paste was printed on the fired titania and fired was repeated 6 times in total to form a titania layer having a thickness of 17 µm on one face of the porous Ti sheet. In this case, the porous Ti sheet was formed to have a size of 9 mm x 24 mm so that both respective end portions were protruded by 2 mm from the titania layer measuring 5 mm x 20 mm. The pore size distribution and the like of the porous Ti sheet were measured by a mercury intrusion method, and it was found that the pore volume was 0.159 cc/g (porosity = 40.1%), the specific surface area was 5.6 m²/g, and the average pore diameter was 8 µm (the pore volumes were 4 to 10 µm at a rate of 60%).

Then, the porous Ti sheet with the titania layer produced was impregnated with a mixed solution of an N719 dye (produced by Solaronix SA) in a mixed solvent of acetonitrile and t-butyl alcohol for 70 hours, thereby allowing the dye to be adsorbed on the surface of the titania. The porous Ti sheet with the titania layer after the adsorption was washed with the mixed solvent of acetonitrile and t-butyl alcohol.

Then, a PET resin sheet with an EVA adhesive layer (opposite substrate), an ITO-deposited PEN resin sheet with a Pt catalyst layer, measuring 9 mm x 24 mm, (cathode electrode), a Ti foil measuring 20 mm x 20 mm, glass paper measuring 10 mm x 25 mm, a Ti foil measuring 20 mm x 20 mm, a porous Ti sheet with a dye-adsorbed titania layer, measuring 9 mm x 24 mm, (anode electrode), and a PET resin sheet with an EVA adhesive layer (transparent substrate) were laminated in this order. In this case, the Ti foil between the cathode electrode and the glass paper was formed so that the end portion thereof was in contact with a longer side of the ITO-deposited PEN resin sheet with a Pt catalyst layer by 2 mm in width and protruded from the glass paper, thereby giving an extending portion. The Ti foil between the anode electrode and the glass paper was formed opposite to the extending portion of the cathode electrode so that the end portion thereof was in contact with a longer side of the porous Ti sheet with a dye-adsorbed titania layer by 2 mm in width and protruded from the glass paper, thereby giving an extending portion. The two PET resin sheets were heat sealed at 100°C by a roller-type laminator. An opening was formed on the PET resin sheet covering the respective extending portions to expose the respective extending portions, thereby forming external connection terminals. In addition, one pore of about 6 mm was provided on the PET resin sheet with an EVA adhesive layer to expose a portion of the porous Ti sheet so that an electrolytic solution could be subsequently injected.

Then, an electrolytic solution of iodine and LiI in an acetonitrile solvent was injected from the pore of about 6 mm to obtain a dye-sensitized solar cell.

The photoelectric conversion performances of the obtained dye-sensitized solar cell were examined by measuring an IV curve under the irradiation with simulated solar light, having an intensity of 100 mW/cm², (using a solar simulator manufactured by Yamashita Denso Corporation) from the side of the dye-adsorbed titania layer. The photoelectric conversion efficiency was 5.0%. 3 Days and 90 days after producing the dye-sensitized solar cell, whether the leakage of the electrolytic solution occurred or not was visually investigated. There was no evidence of the leakage of the electrolytic solution, and also there was no ingress of air observed.

### (Example 2)

A titania paste (trade name: NanoxideD, produced by Solaronix SA) was printed on a range of 96 mm x 96 mm on a porous Ti sheet having a thickness of 100 µm (trade name: Tiporous, produced by Osaka Titanium Technologies Co., Ltd.), dried, and fired in air at 400°C for 30 minutes. An operation in which an additional titania paste was printed on the fired titania and fired was repeated 3 times in total to form a titania layer having a thickness of 10 µm on one face of the porous Ti sheet. In this case, the porous Ti sheet was formed to have a size of 98 mm x 96 mm so that only one side was protruded by 2 mm from the titania layer measuring 96 mm x 96 mm. The pore size distribution and the like of the porous Ti sheet were measured by a mercury intrusion method, and it was found that the pore volume was 0.159 cc/g (porosity = 40.1%), the specific surface area was 5.6 m²/g, and the average pore diameter was 8 µm (the pore volumes were 4 to 10 µm at a rate of 60%).

Then, the porous Ti sheet with the titania layer produced was impregnated with a mixed solution of an N719 dye (produced by Solaronix SA) in a mixed solvent of acetonitrile and t-butyl alcohol for 70 hours, thereby allowing the dye to be adsorbed on the surface of the titania. The porous Ti sheet with the titania layer after the adsorption was washed with the mixed solvent of acetonitrile and t-butyl alcohol.

Then, a PEN resin sheet with an EVA adhesive layer (opposite substrate), a Ti sheet with a Pt catalyst layer, measuring 98 mm x 96 mm, (cathode electrode), a Ti foil measuring 16 mm x 12.5 mm, glass paper measuring 100 mm x 98 mm, a Ti foil measuring 16 mm x 12.5 mm, a porous Ti sheet with a dye-adsorbed titania layer, measuring 98 mm x 96 mm, (anode electrode), and a PEN resin sheet with an EVA adhesive layer (transparent substrate) were laminated in this order and the laminate was obtained. In this case, each of the PEN resin sheets with an EVA adhesive layer of both the opposite substrate and the transparent substrate was formed so that an EVA adhesive layer was provided on the whole surface of the PEN resin sheet and an additional EVA adhesive layer was stacked on the outer edge portion of the EVA adhesive layer by 2 mm in width. In this case, the cathode electrode and the Ti foil were formed so that the end portions thereof were in contact with shorter sides of the Ti sheet with a Pt catalyst layer by 2 mm in width and overlapped, thereby giving extending portions. In addition, the anode electrode and the Ti foil were formed so that the end portions thereof were in contact with shorter sides of the porous Ti sheet with a dye-adsorbed titania layer on the side of the porous Ti sheet by 2 mm in width and overlapped with the same sides as in the case of the extending portion of the cathode, thereby giving extending portions. The laminate was previously kept vacuum by using a hot press equipped with a vacuum apparatus, and then fused under pressure at 130°C. An opening was previously formed on the PEN resin sheet covering the respective extending portions to expose the respective extending portions, thereby forming external connection terminals. In addition, one pore of about 3 mm was provided on the PEN resin sheet with an EVA adhesive layer to expose a part of the porous Ti sheet so that an electrolytic solution could be subsequently injected.

Then, an electrolytic solution of iodine and LiI in an acetonitrile solvent was injected from the pore of about 3 mm to obtain a dye-sensitized solar cell.

The photoelectric conversion performances of the obtained dye-sensitized solar cell were examined by measuring an IV curve under the irradiation with simulated solar light having an intensity of 100 mW/cm² (using a solar simulator manufactured by Yamashita Denso Corporation) from the side of the dye-adsorbed titania layer. The photoelectric conversion efficiency was 3.0%. 90 Days after producing the dye-sensitized solar cell, whether the leakage of the electrolytic solution occurred or not was visually investigated. There was no evidence of the leakage of the electrolytic solution, and also there was no ingress of air observed.

### (Comparative Example)

A dye-sensitized solar cell was produced in the same manner as in Example 1 except for being arranged so that the Ti foil was projected from a sealing portion by the two PET resin sheets with an EVA adhesive layer to the outside.

The photoelectric conversion efficiency of the obtained dye-sensitized solar cell was 5.0%. 3 Days after producing the dye-sensitized solar cell, the dye-sensitized solar cell was visually checked, and as a result, air got in to cause air bubbles in the dye-sensitized solar cell. It is considered that the adhesiveness between the projecting portion of the Ti foil and the resin sheet is insufficient and thus air enters through a gap generated therebetween.

### Reference Signs List

- 10, 10a, 10b: dye-sensitized solar cell
- 12: porous semiconductor layer
- 14, 34: conductive metal layer
- 14a, 16a, 34b, 40b: extending portion
- 16, 40: conductor layer
- 18: laminated structure unit
- 20: electrolyte
- 22: first resin sheet
- 24: second resin sheet
- 26, 28, 44, 46: opening
- 30: transparent substrate
- 32: conductive substrate
- 36: laminated structure
- 38: substrate
- 42: sealing member
- 48a, 48b: resin sheet
- 50: dye-sensitized solar cell module

## Claims

1. A dye-sensitized solar cell provided with a laminated structure unit including a porous semiconductor layer with a dye adsorbed, a conductor layer serving as a cathode electrode, and a conductive metal layer serving as an anode electrode, wherein
respective one end portions of the conductive metal layer and the conductor layer extend from the laminated structure unit to provide respective extending portions; and
the laminated structure unit and the extending portions are sealed together with an electrolyte to be encapsulated, by a sealing material, and parts of the respective extending portions of the conductive metal layer and the conductor layer are exposed from the sealing material to be formed into external connection terminals.

2. The dye-sensitized solar cell according to claim 1, wherein
the conductive metal layer serving as an anode electrode is arranged in contact with the porous semiconductor layer on the side of the conductor layer;
a first resin sheet that has a larger flat surface area than the laminated structure unit, has transparency and is provided with an adhesive agent layer is arranged on the side of the porous semiconductor layer and a second resin sheet that has a larger flat surface area than the laminated structure unit and is provided with an adhesive agent layer is arranged on the side of the conductor layer so that the resin sheets sandwich the laminated structure unit as well as the respective extending portions of the conductive metal layer and the conductor layer;
the respective extending portions of the conductive metal layer and the conductor layer and the outer peripheral portions of the first and second resin sheets, away from the extending portions, are adhered by the first and second resin sheets, and parts of the respective extending portions of the conductive metal layer and the conductor layer are exposed from an opening provided on any one of the first and second resin sheets to be formed into external connection terminals; and
an electrolyte is encapsulated between the conductor layer and the conductive metal layer, and the first resin sheet is defined as a transparent substrate which light enters and the second resin sheet is defined as an opposite substrate.

3. The dye-sensitized solar cell according to claim 2, wherein the first resin sheet and second resin sheet are formed by a self-adhesive resin material.

4. The dye-sensitized solar cell according to claim 1, wherein
a first resin sheet that has a larger flat surface area than the laminated structure unit, has transparency and is provided with an adhesive agent layer is arranged on the side of the porous semiconductor layer and a second resin sheet that has a larger flat surface area than the laminated structure unit and is provided with an adhesive agent layer is arranged on the side of the conductor layer so that the resin sheets sandwich the laminated structure unit as well as the respective extending portions of the conductive metal layer and the conductor layer;
the whole surfaces of the first and second resin sheets are adhered, and parts of the respective extending portions of the conductive metal layer and the conductor layer are exposed from an opening provided on any one of the first and second resin sheets to be formed into external connection terminals; and
an electrolyte is encapsulated, and the first resin sheet is defined as a transparent substrate which light enters and the second resin sheet is defined as an opposite substrate.

5. The dye-sensitized solar cell according to claim 4, wherein the first resin sheet and second resin sheet are formed by a self-adhesive resin material.

6. The dye-sensitized solar cell according to claim 1, provided with a laminated structure including a transparent substrate which light enters, a conductive substrate that is provided opposite to the transparent substrate and serves as a cathode electrode, a porous semiconductor layer with a dye adsorbed, and a conductive metal layer that is arranged in contact with the porous semiconductor layer and serves as an anode electrode, wherein
an electrolyte is encapsulated;
respective one end portions of the conductor layer of the conductive substrate and the conductive metal layer extend from the laminated structure to provide respective extending portions; and
the whole surfaces of the laminated structure as well as the respective extending portions of the conductor layer of the conductive substrate and the conductive metal layer are sealed by a sealing member having transparency, and parts of the respective extending portions of the conductor layer of the conductive substrate and the conductive metal layer are exposed from an opening provided on the sealing member to be formed into external connection terminals.

7. The dye-sensitized solar cell according to claim 6, wherein
the sealing member is constituted by two resin sheets each having an adhesive agent layer provided on the whole surface thereof, at least one of the two resin sheets being made of a transparent material, the resin sheet made of a transparent material is arranged on the transparent substrate, the other resin sheet is arranged below the conductive substrate, and the whole surfaces of the laminated structure as well as the respective extending portions of the conductor layer of the conductive substrate and the conductive metal layer are adhered between the two resin sheets.

8. The dye-sensitized solar cell according to claim 7, wherein
the outer peripheral portions of the two resin sheets each having an adhesive agent layer provided on the whole surface thereof, away from the laminated structure as well as the respective extending portions of the conductor layer of the conductive substrate and the conductive metal layer, are heat sealed.

9. The dye-sensitized solar cell according to any one of claims 4 to 8, wherein the conductive metal layer is a porous layer arranged in contact with the porous semiconductor layer on the side opposite to the transparent substrate.

10. The dye-sensitized solar cell according to claim 9, wherein the extending portion of the conductive metal layer is formed by a non-porous layer.

11. A dye-sensitized solar cell module wherein a multiplicity of the dye-sensitized solar cell according to any one of claims 1 to 8 is arrayed electrically in series or in parallel, and the whole is sealed.

12. A dye-sensitized solar cell module wherein a multiplicity of the dye-sensitized solar cells according to claim 9 is arrayed electrically in series or in parallel, and the whole is sealed.

13. The dye-sensitized solar cell module according to claim 12, wherein the extending portion of the conductive metal layer is formed by a non-porous layer.
